# EUROPÄISCHE PATENTANMELDUNG

(11) **EP 3 009 803 A2**
(43) Veröffentlichungstag der Anmeldung: **20.04.2016**
(21) Anmeldenummer: 15189828.5
(22) Anmeldetag: 14.10.2015
(51) Int. Cl.: G01D 5/14, G01B 7/02

(54) **MAGNETSCHALTER, INSBESONDERE ZUR DETEKTION VON POSITIONEN BEWEGLICHER KOMPONENTEN VON HANDHABUNGSGERÄTEN, UND ZUGEHÖRIGES VERFAHREN**

(30) Priorität: 14.10.2014 DE 102014220812
(71) Anmelder: Schunk GmbH & Co. KG Spann- und Greiftechnik, 74348 Lauffen am Neckar (DE)
(72) Erfinder: Fellhauer, Bruno, 74336 Brackenheim (DE)
(74) Vertreter: DREISS Patentanwälte PartG mbB

(57) **Zusammenfassung**

Magnetschalter (10), insbesondere zur Detektion von Positionen beweglicher Komponenten von Handhabungsgeräten, mit einem Gehäuse, einem im Gehäuse (12)vorgesehen analogen Magnetfeldsensor (14) und einem im Gehäuse vorgesehenen Prozessor (18), **dadurch gekennzeichnet,** dass im Gehäuse ein zum ersten Magnetfeldsensor (14) beabstandet angeordneter zweiter analoger Magnetfeldsensor (16) vorgesehen ist, wobei der Prozessor (18) einen digitalen Ausgang (30) aufweist und die Ausgangssignale der beiden Magnetfeldsensoren (14, 16) vom Prozessor (18) derart verarbeitet werden,
- dass bei Vorbeiführen eines Magnets (20) entlang einer Messstrecke (22, s) Messwerte der beiden Magnetfeldsensoren (14, 16) erfasst werden, wobei jedem Punkt der Messstrecke (22, s) ein eindeutiger Messwert (M) zugeordnet wird,
- wobei die einem Einschaltpunkt (EP) und einem Ausschaltpunkt (AP) zugehörigen Messwerte gespeichert werden, so dass bei bestimmen von Messwerten, die einem zwischen dem Einschaltpunkt (EP) und dem Ausschaltpunkt (AP) liegenden Punkt auf der Messstrecke entsprechen, der digitale Ausgang (30) seinen Wert ändert.

## Beschreibung

Die Erfindung betrifft einen Magnetschalter, insbesondere zur Detektion von Positionen beweglicher Komponenten von Handhabungsgeräten, mit einem Gehäuse, mit einem im Gehäuse vorgesehenen analogen Magnetfeldsensor und einem im Gehäuse vorgesehenen Prozessor.

Derartige Magnetschalter, die insbesondere als Nutenmagnetschalter zum Einsetzen in an Komponenten von Handhabungsgeräten vorgesehene Nuten ausgebildet sein können, sind beispielsweise von der Anmelderin unter der Bezeichnung "Magnetschalter MMS-P" vorbekannt. Diese Magnetschalter erkennen berührungslos die Annäherung eines an einer beweglichen Komponente vorgesehenen Magneten und schalten ab einer gewissen Schaltschwelle ihren Ausgang durch, so dass letztlich ein Ausgangssignal auf "high" oder "low" gesetzt wird. Bekannte Magnetschalter weisen eine Hysterese auf, die insbesondere dann nachteilig ist, wenn Bauteile gehandhabt werden sollen, die samt Toleranz kleiner als die Hysterese des Magnetschalters sind oder wenn die Bauteiltoleranz sehr groß ist. Ein sicheres Erkennen derartiger Bauteile ist dann nicht ausreichend möglich.

Der vorliegenden Erfindung liegt die Aufgabe zugrunde derart bekannte Magnetschalter so weiterzubilden, dass sie den genannten Nachteilen abhelfen.

Diese Aufgabe wird mit einem Magnetschalter mit den Merkmalen des Anspruchs 1 gelöst. Vorgesehen ist folglich, dass im Gehäuse ein zum ersten Magnetfeldsensor beabstandet angeordneter zweiter analoger Magnetfeldsensor vorgesehen ist, wobei der Prozessor einen digitalen Ausgang aufweist und die Ausgangssignale der beiden Magnetfeldsensoren vom Prozessor derart verarbeitet werden, dass beim Vorbeiführen des Magnets entlang einer Messstrecke Messwerte der beiden Magnetfeldsensoren erfasst werden, wobei jedem Punkt der Messstrecke ein eindeutiger Wert zugeordnet wird und dass vorzugsweise eine Linearisierung der Zusammenhänge zwischen den Messwerten und den zugehörigen Punkten auf der Messstrecke erfolgt, wobei die einem Einschaltpunkt und einem Ausschaltpunkt zugehörigen Messwerte gespeichert werden, so dass bei Bestimmen von Messwerten, die einem zwischen dem Einschaltpunkt und dem Ausschaltpunkt liegenden Punkt auf der Messstrecke entsprechen, der digitale Ausgang seinen Wert ändert und insbesondere auf "high" gesetzt wird.

Hierdurch kann gewährleistet werden, dass selbst sehr kleine Bewegungen oder Bauteile, die eigentlich innerhalb der Hysterese eines Magnetfeldsensors liegen, sicher erkannt werden können. Dadurch, dass der Magnetschalter ein digitales Ausgangssignal aufweist, ist eine weitere Nachprogrammierung bzw. Umwandlung des Ausgangssignals nicht erforderlich; es kann sicher festgestellt werden, ob der Magnetschalter ein ("high") oder ausgeschaltet ("low") ist. Das Vorgeben des Einschaltpunktes und des Ausschaltpunktes hat zudem den Vorteil, dass der Magnetschalter auf einfache Art und Weise programmiert werden kann. Der Magnet ist lediglich an den Einschalt- oder Ausschaltpunkt zu bewegen, und die zugehörigen Messwerte sind zu speichern. Dies kann beispielsweise durch Betätigen eines am Magnetschalter vorgesehenen Tasters erfolgen. Der Magnetschalter kann folglich auf einfache Art und Weise eingelernt werden. Dadurch, dass das Ausgangssignal des Magnetschalters digital ist, entfällt ein Mehraufwand bei Inbetriebnahme. Da der Magnetschalter dennoch einen vergleichsweise einfachen Aufbau aufweist ist er kostengünstig in Konstruktion und Fertigung und kann deutlich kleiner bauen als alle vergleichbaren Produkte. Zudem erhöht sich aufgrund des digitalen Ausgangssignals die Störunanfälligkeit des Magnetschalters.

Der Magnetschalter ist vorzugsweise als Nutenmagnetschalter zum Einsetzen in eine an der Komponente eines Handhabungsgeräts vorgesehenen Nut ausgebildet. Insbesondere kann er in Greif- oder Drehmodulen sowie Linearmodulen oder Roboterkomponenten in entsprechend vorgesehenen Nuten Verwendung finden.

Die Erfindung betrifft auch ein Verfahren zum Betreiben eines Magnetschalters mit zwei Magnetfeldsensoren und einem Prozessor mit einem digitalen Ausgang. Das erfindungsgemäße Verfahren kennzeichnet sich durch folgende Schritte:
- Bewegen eines Magnets entlang einer Messstrecke und Erfassen von zugehörigen Messwerten der beiden Magnetfeldsensoren,
- Zuordnen der Messwerte zu Punkten der Messstrecke,
- vorzugsweise Linearisieren der Zusammenhänge zwischen Messwerten und zugehörigen Punkten der Messstrecke,
- Speichern der Messwerte von einem auf der Messstrecke liegenden Einschaltpunkt und einem auf der Messstrecke liegenden Ausschaltpunkt und
- Ändern des Wertes des digitalen Ausgangs auf "high", wenn Messwerte bestimmt werden, denen ein zwischen dem Einschaltpunkt und dem Ausschaltpunkt liegender Punkt auf der Messstrecke entspricht.

Durch Anwenden dieses Verfahrens kann auf einfache Art und Weise und dennoch funktionssicher ein Schalten des Magnetschalters von "low" auf "high" erfolgen, wenn der Magnet zwischen dem Einschaltpunkt und dem Ausschaltpunkt auf der Messstrecke erkannt wird.

Insbesondere eignet sich das erfindungsgemäße Verfahren zum Betreiben eines erfindungsgemäßen Magnetschalters.

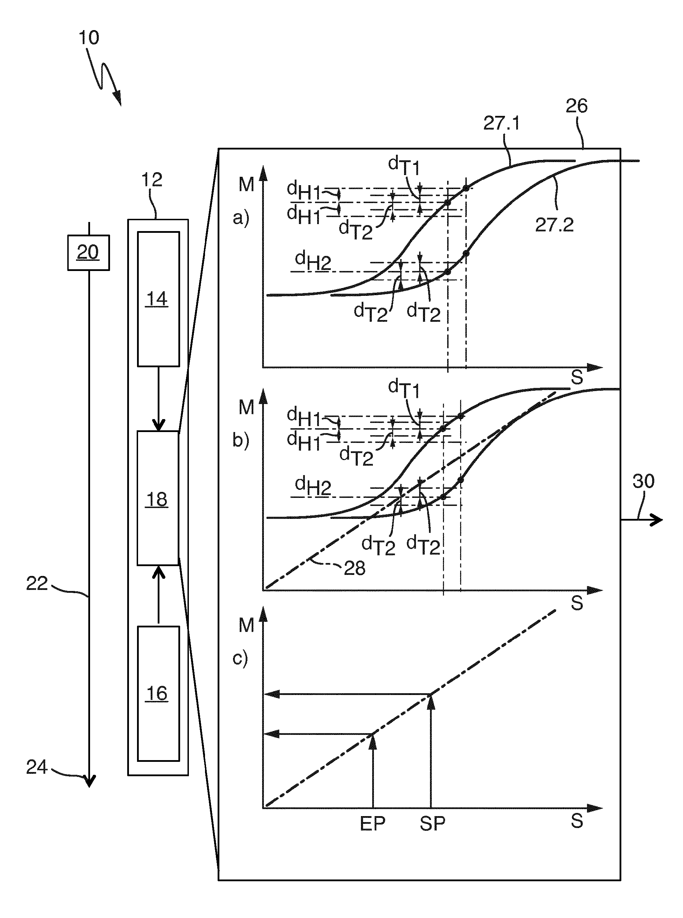

Weitere Vorteile und Vorteilhafte Ausgestaltungen der Erfindung sind der nachfolgenden Beschreibung zu entnehmen, anhand deren ein in der Figur gezeigtes Ausführungsbeispiel näher beschrieben und erläutert wird.

In der Figur ist ein Magnetschalter 10 schematisch dargestellt, der ein Gehäuse 12 aufweist, in dem zwei analoge Magnetfeldsensoren 14 und 16 vorgesehen sind. Zudem ist ein Prozessor 18 im Gehäuse 12 untergebracht, der die Signale der beiden Magnetfeldsensoren 14 und 16 auswertet. Der Magnetschalter 10 dient dabei zur Detektion einer Position eines beispielsweise an einer beweglichen Komponente vorgesehenen Magnets 20, der längs einer Messstrecke 22 entlang des Pfeils 24 bewegbar ist.

Beim Vorbeiführen des Magnets 20 an den Magnetfeldsensoren 14, 16 entlang der Messstrecke 22 werden von den Magnetfeldsensoren 14, 16 analoge Messsignale erzeugt. Der Prozessor 18 bearbeitet diese Messsignale in den Schritten a), b) und c), die in dem der Figur dargestellten Kasten 26 verdeutlicht werden sollen.

In Schritt a) sind die analogen Messwerte M der Magnetfeldsensoren 14 und 16 über der Messstrecke s gezeigt.

Um jeden Punkt der Messstrecke 22 bzw. s einen eindeutigen Messwert zuordnen zu können ist es erforderlich, die beiden Magnetfeldsensoren 14, 16 vorzusehen und deren Ausgangssignale im Schritt a) über die Messstrecke 22 bzw. s aufzutragen und den beiden analogen Signalen einen eindeutigen Messwert M zuzuordnen.

Durch Vorsehen von den beiden beabstandeten Magnetfeldsensoren ist es möglich, eindeutig zu detektieren, ob sich der Magnet 20 im oberen Hystereseabschnitt 27.1 oder im unteren Hystereseabschnitt 27.2 befindet.

Im Schritt b) erfolgt eine Linearisierung der Zusammenhänge zwischen den Messwerten und den zugehörigen Punkten auf der Messstrecke 22, s so dass sich letztlich eine Gerade 28 ergibt.

Im Schritt c) wird dann der Einschaltpunkt EP und der Ausschaltpunkt AP einprogrammiert bzw. gespeichert, so dass sich bei Messwerten M, die sich aus Messpunkten ergeben, die zwischen dem Einschaltpunkt EP und Ausschaltpunkt AP liegen, ein digitales Aussignal erzeugt wird, so dass dieses digitale Ausgangssignal 30 auf "high" gesetzt wird. Messwerte M, die sich aufgrund von Punkten auf der Messstrecke ergeben, die nicht im Intervall zwischen dem Einschaltpunkt EP und Ausschaltpunkt AP liegen, führen zu einem digitalen Ausgangssignal 30, das auf "low" gesetzt wird.

Insgesamt kann hierdurch eine eindeutige Zuordnung der Punkte auf der Messstrecke, die zwischen dem Einschaltpunkt EP und Ausschaltpunkt AP liegen, zu jeweils einem eindeutigen Messwertes erreicht werden, der den digitalen Ausgang auf "high" setzt.

Außerdem wird eine Messungenauigkeit, die auf die Hystereseeigenschaft von Magneten zurückzuführen ist, eliminiert. Weiterhin wird hierdurch eine deutliche Robustheitserhöhung gegenüber Magnetfeldschwankungen durch Temperaturänderungen erreicht.

## Patentansprüche

1. Magnetschalter (10), insbesondere zur Detektion von Positionen beweglicher Komponenten von Handhabungsgeräten, mit einem Gehäuse, einem im Gehäuse (12) vorgesehen analogen Magnetfeldsensor (14) und einem im Gehäuse vorgesehenen Prozessor (18), **dadurch gekennzeichnet, dass** im Gehäuse ein zum ersten Magnetfeldsensor (14) beabstandet angeordneter zweiter analoger Magnetfeldsensor (16) vorgesehen ist, wobei der Prozessor (18) einen digitalen Ausgang (30) aufweist und die Ausgangssignale der beiden Magnetfeldsensoren (14, 16) vom Prozessor (18) derart verarbeitet werden,
- dass bei Vorbeiführen eines Magnets (20) entlang einer Messstrecke (22, s) Messwerte der beiden Magnetfeldsensoren (14, 16) erfasst werden, wobei jedem Punkt der Messstrecke (22, s) ein eindeutiger Messwert (M) zugeordnet wird,
- wobei die einem Einschaltpunkt (EP) und einem Ausschaltpunkt (AP) zugehörigen Messwerte gespeichert werden, so dass beim Bestimmen von Messwerten, die einem zwischen dem Einschaltpunkt (EP) und dem Ausschaltpunkt (AP) liegenden Punkt auf der Messstrecke entsprechen, der digitale Ausgang (30) seinen Wert ändert.

2. Magnetschalter (10) nach Anspruch 1, **dadurch gekennzeichnet, dass** eine Linearisierung der Zusammenhänge zwischen den Messwerten (M) und den zugehörigen Punkten auf der Messstrecke (22, s) erfolgt.

3. Magnetschalter (10) nach Anspruch 1 oder 2, **dadurch gekennzeichnet, dass** der Magnetschalter (10) als Nutenmagnetschalter zum Einsetzen in eine an der Komponente eines Handhabungsgeräts vorgesehenen Nut ausgebildet ist.

4. Verfahren zum Betreiben eines Magnetschalter mit zwei Magnetfeldsensoren (14, 16) und einem Prozessor (18) mit einem digitalen Ausgang (30), **gekennzeichnet durch** folgende Schritte:
- Bewegen eines Magnets (20) entlang einer Messstrecke (22, s) und Erfassen von zugehörigen Messwerten (M) der beiden Magnetfeldsensoren (14, 16),
- Zuordneten der Messwerte (M) zu Punkten der Messstrecke (22, s),
- Speichern der Messwerte (M) von einem auf der Messstrecke (22, s) liegenden Einschaltpunkt (EP) und einem auf der Messstrecke (22, s) liegenden Ausschaltpunkt (AP), und
- Ändern des Wertes des digitalen Ausgangs (30), wenn Messwerte (M) bestimmt werden, denen ein zwischen dem Einschaltpunkt (EP) und dem Ausschaltpunkt (AP) liegender Punkt auf der Messstrecke (22, s)entspricht.

5. Verfahren nach Anspruch 4, **dadurch gekennzeichnet, dass** nach dem Zuordnen der Messwerte (M) zu den Punkten der Messstrecke (ss, s) eine Linearisierung der Zusammenhänge zwischen Messwerten (M) und zugehörigen Punkten der Messstrecke (22, s) erfolgt.

6. Verfahren nach Anspruch 4 oder 5 zum Betreiben eines Magnetschalters (10) nach einem der Ansprüche 1, 2 oder 3.
